# EUROPEAN PATENT SPECIFICATION

(11) **EP 0 366 967 B1**
(45) Date of publication and mention of the grant of the patent: **21.05.1997**
(21) Application number: 89118454.1
(22) Date of filing: 05.10.1989
(51) Int. Cl.: H01L 21/82, H01L 21/74

(54) **A method of forming integrated circuits having buried doped regions**
Verfahren zur Herstellung von integrierten Schaltungen mit vergrabenen dotierten Gebieten
Une méthode de fabrication de circuits intégrés ayant des régions dopées enternées

(30) Priority: 31.10.1988 US 265074
(43) Date of publication of application: 09.05.1990
(73) Proprietor: TEXAS INSTRUMENTS INCORPORATED, Dallas Texas 75265 (US)
(72) Inventor: Bell, David A., Richardson Texas 75080 (US); Havemann, Robert H., Garland Texas 75042 (US)
(74) Representative: Leiser, Gottfried, Dipl.-Ing.

(56) References cited:
- EP-A- 0 067 661
- EP-A- 0 097 379
- EP-A- 0 253 724
- EP-A- 0 278 619

## Description

This application is in the field of methods of forming integrated circuits, and is more specifically directed to the formation of buried doped regions.

### Background of the Invention

In the manufacture of integrated circuits, buried doped regions are often used to provide a low resistivity layer under active portions of the circuit. A common example is the use of such a buried doped region as a subcollector in a conventional vertical bipolar transistor, where a subcollector underlies the base region. Electrical connection to the subcollector is made from the surface at a point separated from the active base-emitter region. As is well known, improved bipolar device performance can be obtained by reducing the collector series resistance through the use of a high doping concentration in the subcollector, and also by the design of active transistor doping profiles to minimize the distance that current must flow from the subcollector through the less heavily doped collector region to the base within the constraint of maintaining an adequate collector-base breakdown voltage.

Buried doped regions are used as subcollectors not only in the fabrication of bipolar integrated circuits, but also in modern BiCMOS integrated circuits which include bipolar transistors and MOS transistors of both channel conductivity types in the same chip. In BiCMOS circuits, buried doped regions are used as a subcollector for the bipolar transistor, and also at the bottom of the n-type (and p-type) wells into which the MOS transistors are formed. N+ buried doped regions under n-wells, and p+ buried doped regions under p-wells, each provide for uniform bias of the overlying wells, improving the transistor performance. In addition, the use of buried doped regions underlying the wells reduces the tendency of the parasitic SCR formed by adjacent n-channel and p-channel MOS transistors to "latch-up." An example of the use of n+ and p+ buried doped regions in a BiCMOS structure is described in copending application S.N. 129,271, filed December 7, 1987 and assigned to Texas Instruments Incorporated, which corresponds to EP-A-0 320 217.

As the feature sizes for modern integrated circuits become smaller, full realization of the increased density available from transistors having such smaller feature sizes becomes possible only if the devices can be placed closer together. The use of buried doped regions, however, is a limitation on the spacing of active devices from one another, as buried doped regions of common conductivity type which are associated with adjacent transistors must be electrically isolated.

One prior technique for such isolation includes the use of trench isolation between buried doped regions, as described in copending application S.N. 129,270 now US-A-4,835,115 filed December 7, 1987 and assigned to Texas Instruments Incorporated. While such techniques effectively provide electrical isolation, the etching and refilling of trenches adds process complexity and cost to the manufacture of the device.

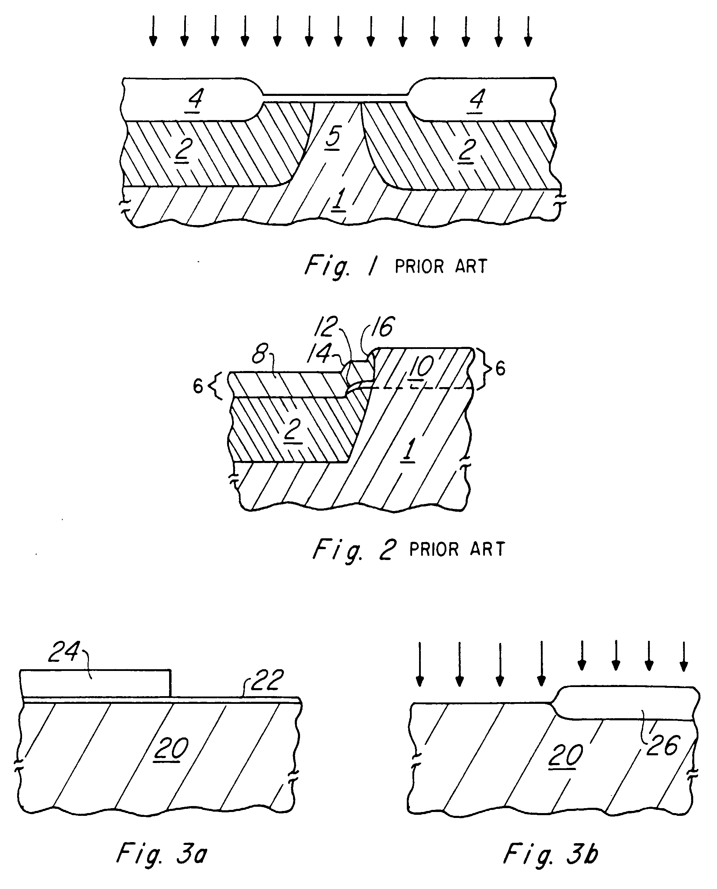

A less costly, and more conventionally used, technique for providing isolation between buried doped regions is to dope the space therebetween with dopant of the opposite conductivity type. Referring to Figure 1, such a conventional technique will be illustrated. According to conventional methods for forming buried doped regions, a nitride mask (generally overlying an oxide buffer pad) is provided over locations where the buried doped regions are not to be formed. N-type dopant is then introduced into the substrate 1 (generally lightly doped p-type) at the locations not covered by the silicon nitride mask. For n-type buried doped regions 2, antimony is a commonly used dopant due to its relatively slow diffusion rate in silicon, which provides for a greater degree of control of the placement of buried doped region 2 as compared with a dopant such as phosphorus. The structure is then annealed in an oxidizing atmosphere (for example, at a high temperature such as 1250 degrees Celsius) to drive-in the n-type dopant to form the n+ buried doped regions 2, and to form a thermal oxide layer 4 at the locations where the nitride mask is not present. The nitride mask is then removed, resulting in the structure shown in Figure 1. In order to provide isolation between buried doped regions 2, it is desirable that the region 5 of substrate 1 disposed therebetween be more heavily doped than the substrate doping level to provide the desired electrical isolation therebetween. The thermal oxide layer 4 serves as a mask for the p-type implant (generally using boron) illustrated in Figure 1 as doping the region 5 between buried doped regions 2. Use of this layer as a mask provides for a self-aligned process, as no additional masking layers, which must be aligned with the edges of the buried doped regions 2, are necessary.

However, use of the thermal oxide layer 4 as the mask for the boron implant as described above presents problems in the formation of the isolation region, and especially presents problems to the scaling of the resulting structure. When using the oxide layer 4 as a mask, the energy of the boron implant must be sufficiently low so that the oxide layer 4 indeed masks the implant, preventing counterdoping of buried doped regions 2. However, since the next step after formation of the isolation region normally involves an in situ silicon etch to clean the surface of substrate 1 prior to epitaxial silicon formation, the energy of the boron implant must be high enough so that a majority of the implanted region remains behind after this etch. It should further be noted that the thickness of the oxide layer 4 cannot be arbitrarily increased to serve as a better mask, since the topography of the surface of substrate 1 will be even less planar than is shown in Figure 1, resulting in further problems during subsequent processing.

It should further be noted that, as shown in Figure 1, the oxide layer 4 over buried doped regions 2 does not extend to the edges of buried doped regions 2, since buried doped regions 2 (even with antimony as the dopant) laterally diffuse during the anneal faster than the oxide layer 4 encroaches under the nitride mask. Accordingly, since the boron implant energy is held low enough to not penetrate the oxide layer 4, a region of boron will be formed near the surface, overlying the edges of buried doped regions 2. Referring to Figure 2, another location of the same structure as Figure 1 is illustrated, showing the boundary between a buried doped region 2 over which an n-well is to be formed, and an adjacent p-well. After the formation of an epitaxial layer 6, into which n-well 8 and p-well 10 are formed for the MOS transistors in a CMOS process, the boron layer formed at the surface of the n+ buried doped region 2 near its edges (i.e., where not covered by oxide layer 4) has out-diffused into the epitaxial layer 6, forming a filament 12 of p-type material which extends between n-well 8 and its underlying buried doped region 2.

Further with reference to Figure 2, it should be noted that the topography of the structure is far from planar. A first step 14 is formed by the consumption of substrate 1 during the formation of buried doped region 2, as described above relative to Figure 1. In addition, conventional processing methods for forming self-aligned twin wells often further form a second step 16. In such a conventional method, n-well 8 is formed in the same manner as buried doped region 2 described above, since the n-well 8 is implanted with a mask over the region where p-well 10 is to be formed, followed by an anneal in an oxidizing atmosphere to form a well masking oxide layer over the n-well 8. This well masking oxide layer (not shown) masks the p-type boron implant used to form p-well 10 from the n-well 8, in similar fashion as oxide layer 4 masked the isolation implant from buried doped regions 2. However, the result is a second step 16 in the topography, aggravating the non-coplanarity of the resulting structure. Such steps in the surface topography create step coverage problems for overlying conductive layers, and also require the use of increased overetch of such conductive layers to clear filaments remaining at the bottom of the steps after anisotropic etching. Such an overetch reduces the line width of the remaining lines, and also places severe constraints on the selectivity properties of the etch. Steps in the surface topography also reduce the ability to reliably form electrical contact to the surface of the p-well 10 and the surface of the n-well 8 using the same pattern and etch steps. In addition, the difference in height between the surfaces of the n-well 8 and p-well 10 reduces the ability to photolithographically pattern features at the surface of the structure, since the depth of focus in the patterning of sub-micron features may not be as large as the step from the surface of n-well 8 to the surface of p-well 10.

It has also been noted that the presence of a masking nitride layer over silicon during a high temperature anneal (such as the buried doped region anneal described above) provides the possibility of defects generated in the silicon surface underlying the nitride masking layer, especially in the presence of a heavily doped region such as the buried doped region.

In EP-A-0 278 619 a method of forming buried doped regions is disclosed in which an oxide layer is used as a mask for the isolation implant. The isolation dopant is not implanted through the oxide layer and therefore the region where the buried doped region is being formed is not counter doped.

A further method of forming buried doped regions is disclosed in EP-A-0 253 724 in which a photoresist mask on the isolation regions is removed prior to the blanket isolation implant.

It is therefore an object of this invention to provide a method for formation of buried doped regions in an integrated circuit which allows for a high energy implant of isolating dopant therebetween, thereby providing for smaller spacing requirements.

It is another object of this invention to provide such a method which results in improved planar topography over prior methods.

It is another object of this invention to provide such a method which has reduced defect density after the annealing steps.

It is yet another object of this invention to provide the above benefits without the addition of a masking step.

Other objects and advantages of the invention will become apparent to those of ordinary skill in the art having reference to the following specification in conjunction with the drawings.

### Summary of the Invention

According to the method of the invention, an integrated circuit is fabricated at a surface of a semiconductor of a first conductivity type, said method comprising the steps defined in claim 1.

### Brief Description of the Drawings

Figure 1 is a cross-sectional diagram of an integrated circuit containing a pair of n-type buried doped regions, at a particular stage of formation according to the prior art.

Figure 2 is a cross-sectional diagram of the integrated circuit of Figure 1 at the edge of an n-type buried doped region with an n-well thereover and adjacent a p-well, at a particular stage of formation according to the prior art.

Figures 3a through 3i are cross-sectional diagrams of an integrated circuit at various stages of construction according to the method of the invention and further examples which are not part of the invention.

Figure 4 is a cross-sectional diagram of the integrated circuit of Figure 3i at a location having adjacent n-type buried doped regions, constructed according to the invention.

### Detailed Description

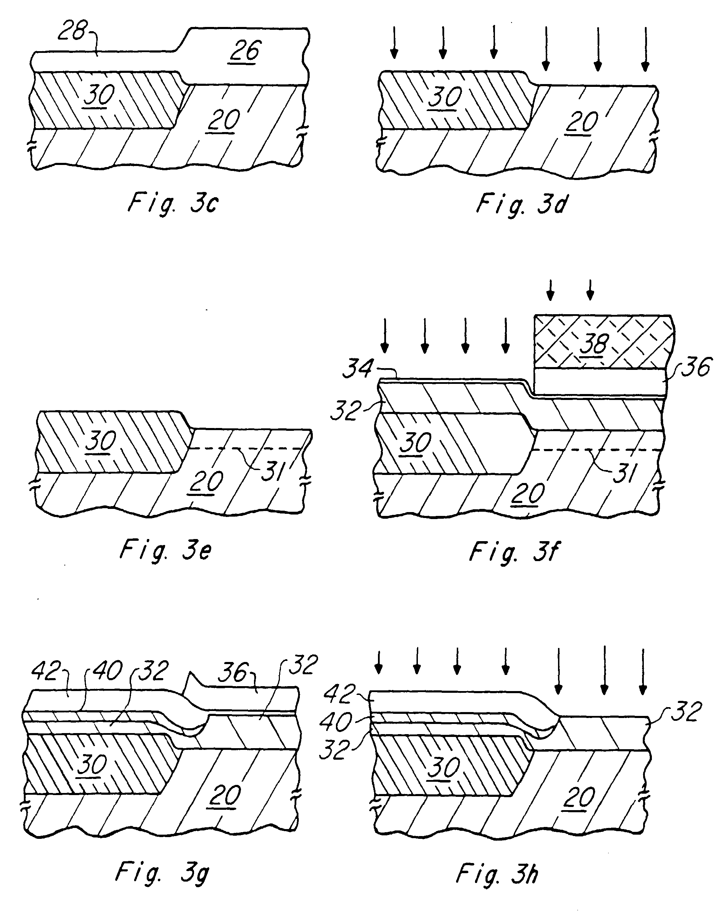

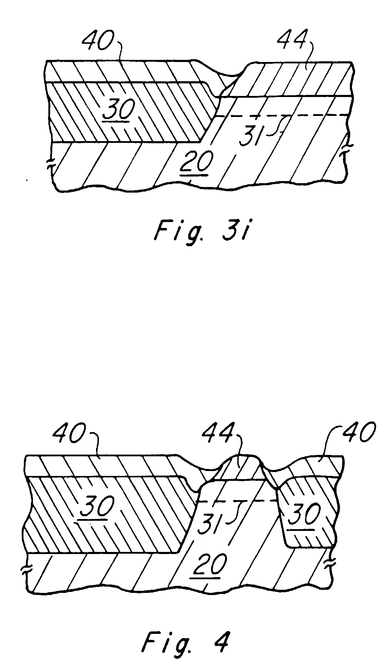

Referring to Figures 3a through 3i, the construction of an integrated circuit according to the invention will be described in detail. The structure of Figure 3a illustrates a p-type substrate 20 which, according to a first embodiment of the invention, is relatively lightly doped, for example on the order of 1E15 to 2E15 cm⁻³. By way of thermal oxidation, a thin layer of pad oxide 22 of a thickness on the order of 25 to 50 nm is formed over the surface of the substrate. A masking layer 24 of silicon nitride is then deposited by way of CVD to a thickness on the order of 100 to 150 nm. Conventional photolithography is then used to define the portions of nitride layer 24 which are to remain, and an etch is performed to remove the undesired portions, resulting in the structure of Figure 3a. It should be noted that the pad oxide layer 22 is used, as is well known in the art, to minimize mechanical stress during the nitride deposition, etch, and oxidation steps. According to the invention, nitride layer 24 is left in place over the portion of the substrate 20 at which the n+ buried doped regions are to be formed, as will be evident later.

The structure of Figure 3a is then placed in an oxidizing environment in order to form silicon dioxide layer 26 shown in Figure 3b, to a thickness on the order of 300 to 600 nm. It should be noted that a portion of substrate 20 is of course consumed in the formation of oxide layer 26, and that the nitride mask layer 24 serves as a barrier to oxygen atoms, so that oxidation does not occur thereunder. While the above description f the method of forming oxide layer 26 is according to the well known local oxidation of silicon (LOCOS) technique, it should of course be noted that other techniques for forming oxide layer 26 are equally applicable in the method according to the invention, including the poly-buffered LOCOS technique described in U.S. Patent No. 4,541,167 issued September 17, 1985 and assigned to Texas Instruments Incorporated. Nitride layer 24 is then stripped, and pad oxide 22 removed by way of a short deglaze, exposing the portion of substrate 20 into which the n+ buried doped region is to be formed, as illustrated in Figure 3b. The structure is then subjected to ion implantation of an n-type dopant, preferably antimony or arsenic, which is performed at the desired dose and energy to form the eventual n+ buried doped region. The energy of the implant should, of course, be selected so that oxide layer 26 acts as a mask to the implant. An example of the implant used to form this region is an antimony implant at an energy on the order of 40 keV, at a dose on the order of 5E15 cm⁻². Alternatively, a higher energy implant, such as 100 keV antimony, may be performed without removing pad oxide 22. Such a higher energy implant can implant the dopant through pad oxide 22, but not through oxide layer 26, thereby eliminating the step of the deglaze to remove pad oxide 22.

Subsequent to the n-type implant, an anneal is performed in an oxidizing atmosphere at a high temperature, for example on the order of 1250 degrees Celsius for an antimony implant, to drive the implanted ions and form the n+ buried doped region 30 of Figure 3c. In this example, the resultant buried doped region will have a high peak doping concentration, for example on the order of 1E19 cm⁻³. This anneal will form an oxide layer over the surface of buried doped region 30, and will of course further oxidize the remainder of the structure to slightly increase the thickness of oxide layer 26, as shown in Figure 3c. Aside from greatly retarding the oxidation of the substrate 20 thereunder, oxide layer 26 also inhibits the lateral diffusion of the n+ buried doped region 30 during this anneal, since the recessed portion of oxide layer 26 presents a diffusion barrier to the implanted n-type dopant. It should be noted that there is no silicon nitride layer on the surface of substrate 20 during this anneal. It has been found that the presence of a nitride layer during this high temperature anneal, in conjunction with a heavily doped region such as n+ region 30, can form defects in the underlying silicon which will render inoperative transistors formed in the affected areas. The method according to the invention described herein allows this anneal to be performed without such a nitride layer, improving the manufacturability of the integrated circuit so constructed.

In an example which is not part of the invention, oxide layers 26 and 28 are then removed. According to this example, utilizing a relatively lightly-doped p-type substrate, a blanket p-type implant is then performed as illustrated in Figure 3d. The purpose of this implant is to increase the isolation between neighboring n+ buried doped regions 30, as described hereinabove. This implant can be done in blanket fashion and at a high energy, as is preferred for isolation purposes, since the high doping concentration of n+ buried doped region 20 will retard the diffusion of the boron dopant therewithin. The retarded diffusion of boron in n+ buried doped region 30 can thus prevent the counterdoping of the surface of buried doped region 30 (as illustrated in Figure 2), so that the interface between buried doped region 30 and the n-well which will be formed thereover will not be compromised by the boron implant. In the portion of substrate 20 where n+ buried doped regions 30 are not located, the diffusion of the boron dopant will not be so retarded, so that boron dopant will diffuse upwardly to make good contact with the p-well to be formed thereover, as well as to provide good isolation between neighboring n+ buried doped regions 30. Since the implant is done without an oxide mask as shown in Figure 1, the energy of the implant can be set to a high level, for example on the order of 100 to 300 keV or higher, to achieve the desired isolation characteristics. It should be noted that this boron implant can be of a sufficiently high dose (for example, 1E12 to 1E13 cm⁻² to form a p-type buried doped region, serving similar functions as n+ buried doped regions 30, if so desired. The location of the more highly doped p-type region is indicated by dashed line 31 in Figure 3e.

According to the invention, the energy of the boron implant is increased to a very high value, for example exceeding 300 keV, and the implant shown in Figure 3c is performed with oxide layers 26 and 28 in place. Such a high energy implant locates the implanted boron even deeper into n+ buried doped region 30, further reducing the extent to which the boron may updiffuse into the epitaxial layer which will be formed thereover. Oxide layers 26 and 28 are removed after the implant, and prior to formation of an epitaxial layer, described below.

According to an example which is not part of the invention, a more heavily doped p-type substrate 20 may be used, for example having a dopant concentration on the order of 1E16 to 5E16 or higher, which can allow elimination of the boron implant step described immediately above. Such a substrate concentration can provide sufficient isolation between neighboring n+ buried doped regions 30. Diffusion of this additional concentration of boron in substrate 20 will also be retarded within n+ buried doped regions 30 as in the case of the implant, allowing a good interface between n+ buried doped regions 30 and the n-wells to be formed thereover. In addition, boron from substrate 20 will segregate into the oxide layer 28 overlying n+ buried doped regions 30, further reducing the boron surface concentration in this alternate embodiment of the invention.

Referring now to Figure 3f, the remainder of the process according to the invention will be described. It should be noted that the following steps may be performed in combination with either of the above-described alternatives (i.e., with or without the boron implant of Figure 3d). An epitaxial layer 32 is grown according to conventional techniques on the surface of the structure of Figure 3e, to the desired thickness. It is preferable for the performance of bipolar transistors that the epitaxial layer 32 be relatively thin (for example on the order of 0.75 to 1.50 microns), and for the performance of the n-channel MOS transistors that epitaxial layer 32 be relatively lightly doped, approaching intrinsic levels. However, for the purpose of the instant invention, it should be noted that the thickness and the doping concentration of epitaxial layer 32 is arbitrary, and depends upon the type and performance of the resulting integrated circuit.

Subsequent to the formation of epitaxial layer 32, formation of the n-wells and p-wells into which the active devices will be formed is then accomplished. For formation of an n-well overlying n+ buried doped region 30, a pad oxide 34 is again formed (as in the method of forming n+ buried doped region 30 described hereinabove) to a thickness on the order of 25 to 50 nm. Masking nitride layer 36 is deposited, followed by the deposition of a photoresist layer 38 which is photolithgraphically patterned and developed to define the location of the n-well, and nitride layer 36 is removed therefrom, resulting in the structure of Figure 3f. The location of the edge of photoresist layer 38 (and nitride layer 36) can be aligned with the small step in epitaxial layer 32 which resulted from the consumption of substrate 20 during the formation of oxide layer 26 in Figure 3b. N-type dopant is then implanted for the formation of the n-well, with photoresist 38 and nitride layer 36 masking the implant from the locations at which the n-well is not to be formed. An example of an n-well implant into a very lightly doped epitaxial layer is a two step implant, consisting of a first implant of phosphorous at a dose on the order of 1E12 cm⁻² at 70 keV followed by a second phosphorous implant at a dose of 1.2E12 cm⁻² at 350 keV. Of course, a single step n-well implant, and other doses, energies or dopant species may be used depending upon the desired well characteristics. Following the n-well implant, photoresist layer 38 is stripped, and a thick oxide layer 42 is thermally formed over the implanted region as shown in Figure 3g. Oxide layer 42 will selectively form over n-well 40 due to the presence of nitride layer 36; an exemplary thickness for oxide layer 42 is on the order of 300 to 500 nm. The n-type implanted region will diffuse to some extent during this oxidation to begin the formation of n-well 40, as also shown in Figure 3g. Of course, a portion of the surface of n-well 40 is consumed by this oxidation; since, however, the surface of epitaxial layer 32 at this location was higher than the surface not overlying n+ buried doped region 32, this oxidation tends to reduce the step as shown in Figure 3g. A dip will still be present between the edge of n-well 40 and the original edge of n+ buried doped region 30, since these boundaries do not necessarily coincide. However, this dip is located at a portion of the structure at which it is unlikely that any active devices will be formed, and the depth of this dip is relatively shallow so that undesirable effects from the dip are reduced.

After the formation of oxide layer 42, nitride layer 36 is removed, and a boron implant is then performed, using oxide layer 42 as a mask to prevent the counterdoping of the n-well by the boron implant. An example of the dose and energy for such an implant is a dose of 1E12 cm⁻² at an energy on the order of 50 keV. After the implant, a drive-in anneal for the wells is performed in an inert atmosphere to diffuse the dopants to the desired well depth. Oxide layer 42 may be removed either prior to, or after, the well drive-in anneal. The resultant structure is illustrated in Figure 3i, showing the formation of p-well 44 overlying the portion of substrate 20 not having n+ buried doped region 30 (and, in the case of the implanted isolation layer, overlying the boron implanted region 31).

As is apparent from Figure 3i, the top surface of n-well 40 and p-well 44 are relatively coplanar, especially when compared against the prior technique illustrated in Figure 2. This improved topography results in improved photolithgraphy capability for the structure in later steps, since the topography is more likely to be within the depth of focus of the photolithographic exposure equipment. In addition, planarization of overlying dielectric material is facilitated since the steps at the surface of the structure are of reduced height, thereby reducing the length of any etchback used in such planarization. In the event that such planarization is used, the formation of contact openings through such an overlying oxide is facilitated since the depth of the openings to n-well 40 and p-well 44 will be virtually identical, reducing the possibility that contact to the lower surface will require longer etching than contact to the upper surface. In addition, the resultant structure provides for a smoother topography over which conductive layers (such as polysilicon or metal) may be formed, reducing the problems associated with step coverage often encountered in structures having a non-coplanar topography.

Figure 4 illustrates another location of an integrated circuit showing neighboring n+ buried doped regions 30, with a portion of p-type substrate 20 disposed therebetween. In this case, p-well 44 will not contain any active devices but, in combination with the increased p-type doped region 31, will provide good electrical isolation between n+ buried doped regions 30, even if closely spaced as shown in Figure 4.

Subsequent to the completion of the method described hereinabove, transistors and other elements, as well as connections therebetween, are formed into p-well 44 and n-well 40. An example of such structures and a method for their formation is described in said copending application S.N. 129,271. Individual circuits are then separated from portions of substrate 20, and external connections made thereto by way of wire bonding, direct bump connection, or the like, as is well known in the art. The individual circuits may then be packaged into a dual-in-line package, a chip carrier, or another type of package. An example of such a package is described in U.S. Patent No. 4,495,376 issued January 22, 1985 and assigned to Texas Instruments Incorporated.

## Claims

1. A method of fabricating an integrated circuit at a surface of a semiconductor (20) of a first conductivity type, comprising:
forming a first oxide layer (26) at a first location of the surface;
doping a second location (30) of the surface not masked by the first oxide layer, by implanting a dopant of a second conductivity type;
annealing the semiconductor in an oxidizing ambient thereby diffusing said dopant into the second location and thereby thickening said first oxide layer and forming a second oxide layer (28) on the surface at the second location;
implanting both said first and said second location with dopant of the first conductivity type through said first and second oxide layers;
removing the oxide layers;
forming an epitaxial layer over said first and second locations after said implanting step, so that said doped second location of the surface forms a buried doped region.

2. The method of claim 1, wherein said step of forming said first oxide layer comprises:
forming a mask (24) over said second location of said surface, but not said first location of said surface, said mask being a barrier to oxidation; and
heating the semiconductor in an oxidizing atmosphere to form said first oxide layer at said first location of said surface.

3. The method of any preceding claim, further comprising:
forming a second mask layer (36, 38) over said epitaxial layer at a location overlying said first location of said surface;
implanting said epitaxial layer with dopant of said second conductivity type at a location overlying said buried doped region, said second mask layer preventing the dopant from reaching the portion of the epitaxial layer lying thereunder; and
heating said semiconductor to diffuse the dopant in said epitaxial to form a well of said second conductivity type.

4. The method of claim 3, wherein said heating step is done in an oxidzing atmosphere to form a well oxide layer (42) overlying said well.

5. The method of claim 4, further comprising:
removing said second mask layer;
implanting said epitaxial layer with dopant of said first conductivity type, said well oxide layer preventing the dopant of said first conductivity type from reaching said well of said second conductivity type; and
heating said semiconductor to diffuse the implanted dopant of said first conductivity type in said epitaxial layer to form a well of said first conductivity type.

6. The method of any of claims 3 to 5, wherein said buried doped region is formed to be more highly doped than said well of said second conductivity type.

7. The method of any preceding claim, wherein the doping concentration of said buried doped region is higher than the doping concentration of said semiconductor.

8. The method of any preceding claim, wherein the doping concentration of said first location after said implanting step is approximately one order of magnitude greater than that of said semiconductor.

## Patentansprüche

1. Verfahren zum Herstellen einer integrierten Schaltung auf einer Fläche eines einen ersten Leitfähigkeitstyp aufweisenden Halbleiters (20), umfassend:
es wird eine erste Oxidschicht (26) an einer ersten Stelle der Fläche gebildet;
es wird eine zweite, nicht von der ersten Oxidschicht maskierte Stelle (30) der Fläche durch Implantieren eines Dotierstoffs eines zweiten Leitfähigkeitstyps dotiert;
es wird der Halbleiter in einer oxidierenden Umgebung ausgeheizt, wodurch der Dotierstoff in das Gebiet der zweiten Stelle diffundiert und die erste Oxidschicht verdickt wird, und es wird eine zweite Oxidschicht (28) auf der Fläche an der zweiten Stelle gebildet;
es werden das Gebiet der ersten Stelle und das Gebiet der zweiten Stelle durch die erste Oxidschicht und die zweite Oxidschicht hindurch mit einem Dotierstoff des ersten Leitfähigkeitstyps dotiert;
es werden die Oxidschichten entfernt;
es wird nach dem Implantationsschritt eine expitaxiale Schicht über der ersten Stelle und der zweiten Stelle gebildet, so daß die dotierte zweite Stelle der Fläche eine vergrabene dotierte Zone bildet.

2. Verfahren nach Anspruch 1, bei dem der Schritt des Bil-dens der ersten Oxidschicht umfaßt:
es wird über der zweiten Stelle der Fläche, jedoch nicht über der ersten Stelle der Fläche, eine Maske (24) gebildet, die eine Sperrschicht für die Oxidation darstellt; und
es wird der Halbleiter in einer oxidierenden Umgebung aufgeheizt, um die erste Oxidschicht an der ersten Stelle der Fläche zu bilden.

3. Verfahren nach einem der vorhergehenden Ansprüche, darüber hinaus umfassend:
es wird eine zweite Maskensschicht (36, 38) über der expitaxialen Schicht an einer Stelle gebildet, die über der ersten Stelle der Fläche liegt;
es wird die epitaxiale Schicht mit einem Dotierstoff des zweiten Leitfähigkeitstyps an einer Stelle dotiert, die über der vergrabenen Zone liegt, wobei die zweite Maskenschicht den Dotierstoff davon abhält, den Teil der epitaxialen Schicht zu erreichen, der unter der zweiten Maskenschicht liegt; und
es wird der Halbleiter aufgeheizt, um den Dotierstoff in die epitaxiale Schicht zu diffundieren, um eine Wanne zu bilden, die den zweiten Leitfähigkeitstyp aufweist.

4. Verfahren nach Anspruch 3, bei dem der Aufheizschritt in einer oxidierenden Umgebung durchgeführt wird, um eine Wannenoxidschicht (42) über der Wanne zu bilden.

5. Verfahren nach Anspruch 4, darüber hinaus umfassend:
es wird die zweite Maskenschicht entfernt;
es wird die epitaxiale Schicht mit einem Dotierstoff des ersten Leitfähigkeitstyps implantiert, wobei die Wannenoxidschicht den Dotierstoff des ersten Leitfähigkeitstyps davon abhält, die den zweiten Leitfähigkeitstyp aufweisende Wanne zu erreichen; und
es wird der Halbleiter aufgeheizt, um den implantierten Dotierstoff des ersten Leitfähigkeitstyps in die epitaxiale Schicht zu diffundieren, um eine Wanne zu bilden, die den ersten Leitfähigkeitstyp aufweist.

6. Verfahren nach einem der Ansprüche 3 bis 5, bei dem die vergrabene dotierte Zone so gebildet wird, daß sie stärker dotiert ist als die den zweiten Leitfähigkeitstyp aufweisende Wanne.

7. Verfahren nach einem der vorhergehenden Ansprüche, bei dem die Dotierstoffkonzentration der vergrabenen dotierten Zone größer als die Dotierstoffkonzentration des Halbleiters ist.

8. Verfahren nach einem der vorhergehenden Ansprüche, bei dem die Dotierstoffkonzentration der ersten Stelle nach dem Implantationsschritt um ungefähr eine Größenordnung über derjenigen des Halbleiters liegt.

## Revendications

1. Procédé pour fabriquer un circuit intégré sur une surface d'un semiconducteur (20) possédant un premier type de conductivité, consistant à :
former une première couche d'oxyde (26) en un premier emplacement de la surface;
doper un second emplacement (30) de la surface non masquée par la première couche d'oxyde, moyennant l'implantation d'un dopant possédant un second type de conductivité;
appliquer un recuit au semiconducteur dans une atmosphère oxydante de manière à faire diffuser ledit dopant au niveau du second emplacement et de ce fait épaissir ladite première couche d'oxyde et former une seconde couche d'oxyde (28) sur la surface au niveau du second emplacement;
implanter à la fois audit premier emplacement et audit second emplacement un dopant possédant le premier type de conductivité, à travers lesdites première et seconde couches d'oxyde;
retirer les couches d'oxyde;
former une couche épitaxiale au-dessus desdits premier et second emplacements après ladite étape d'implantation, de sorte que ledit second emplacement dopé de la surface forme une région dopée ensevelie.

2. Procédé selon la revendication 1, selon lequel ladite étape de formation de ladite première couche d'oxyde comprend :
la formation d'un masque (24) au-dessus dudit second emplacement de ladite surface, mais pas au-dessus dudit premier emplacement de ladite surface, ledit masque étant une barrière contre l'oxydation; et
le chauffage du semiconducteur dans une atmosphère oxydante pour former ladite première couche d'oxyde audit premier emplacement de ladite surface.

3. Procédé selon l'une quelconque des revendications précédentes, comprenant en outre :
la formation d'une seconde couche de masque (36,38) au-dessus de ladite couche épitaxiale en un emplacement recouvrant ledit premier emplacement de ladite surface;
l'implantation, dans ladite couche épitaxiale, du dopant possédant ledit second type de conductivité en un emplacement recouvrant ladite région dopée ensevelie, ladite seconde couche formant masque empêchant le dopant d'atteindre la partie de la couche épitaxiale située au-dessous; et
le chauffage dudit semiconducteur pour faire diffuser le dopant dans ladite couche épitaxiale pour former un puits possédant ledit second type de conductivité.

4. Procédé selon la revendication 3, dans lequel ladite étape de chauffage est exécutée dans une atmosphère oxydante pour former une couche d'oxyde de puits (42) recouvrant ledit puits.

5. Procédé selon la revendication 4, comprenant en outre :
l'élimination de ladite seconde couche de masque;
l'implantation, dans ladite couche épitaxiale, d'un dopant possédant ledit premier type de conductivité, ladite couche d'oxyde de puits empêchant que le dopant possédant ledit premier type de conductivité n'atteigne ledit puits possédant ledit second type de conductivité; et
le chauffage dudit semiconducteur pour faire diffuser le dopant implanté possédant ledit premier type de conductivité dans ladite couche épitaxiale pour former un puits possédant ledit premier type de conductivité.

6. Procédé selon l'une quelconque des revendications 3 à 5, selon lequel ladite région dopée ensevelie est agencée de manière à être plus fortement dopée que ledit puits possédant ledit second type de conductivité.

7. Procédé selon l'une quelconque des revendications précédentes, selon lequel la concentration de dopage de ladite région dopée ensevelie est supérieure à la concentration de dopage dudit semiconducteur.

8. Procédé selon l'une quelconque des revendications précédentes, selon lequel la concentration de dopage dudit premier emplacement après ladite étape d'implantation est supérieure approximativement d'un ordre de grandeur, à celle dudit semiconducteur.
